# EUROPEAN PATENT SPECIFICATION

(11) **EP 3 457 434 B1**
(45) Date of publication and mention of the grant of the patent: **18.11.2020**
(21) Application number: 17190747.0
(22) Date of filing: 13.09.2017
(51) Int. Cl.: H01L 23/52, H01L 23/373, H01L 23/498

(54) **METHOD FOR PRODUCING A SEMICONDUCTOR SUBSTRATE FOR A POWER SEMICONDUCTOR MODULE ARRANGEMENT**
VERFAHREN ZUR HERSTELLUNG EINES HALBLEITERSUBSTRATS FÜR EINE LEISTUNGSHALBLEITERMODULANORDNUNG
PROCÉDÉ DE FABRICATION D'UN SUBSTRAT SEMI-CONDUCTEUR POUR UN AGENCEMENT DE MODULE SEMI-CONDUCTEUR DE PUISSANCE

(43) Date of publication of application: 20.03.2019
(73) Proprietor: Infineon Technologies AG, 85579 Neubiberg (DE)
(72) Inventor: Roth, Alexander, 93197 Zeitlarn (DE); Hohlfeld, Olaf, 59581 Warstein (DE)
(74) Representative: Westphal, Mussgnug & Partner Patentanwälte mbB

(56) References cited:
- JP-A- 2003 198 104
- JP-A- 2014 056 933
- US-A1- 2011 127 562
- US-A1- 2013 277 846
- US-A1- 2014 138 710

## Description

### TECHNICAL FIELD

The instant disclosure relates to a method for producing a semiconductor substrate for a power semiconductor module arrangement.

### BACKGROUND

Power semiconductor module arrangements usually include at least one isolating substrate. A semiconductor arrangement including a plurality of controllable semiconductor elements (e.g., two IGBTs in a half-bridge configuration) is arranged on the at least one substrate. Electrical connections between the separate substrates and the semiconductor elements arranged on the substrates usually include wires such as bonding wires, for example. Each of the substrates usually comprises an isolating substrate layer (e.g., a ceramic layer, a polymer layer, or a polymer/ceramic matrix), a first metallization layer (e.g., copper, or aluminium) deposited on a first side of the substrate layer and a second metallization layer (e.g., copper, or aluminium) deposited on a second side of the substrate layer. The one or more substrates may be arranged in a housing. Some power semiconductor modules further include a base plate on which the semiconductor substrate is mounted. The semiconductor arrangements today are becoming more and more complex and have an increasing package density and the requirements for substrates, therefore, are also changing. For example, the increasing complexity of the semiconductor arrangements often requires a great number of electrical connections between the semiconductor elements. To accomplish all required connections, often further horizontal metallization layers, in addition to metallization layers already present on the semiconductor substrate, are necessary. However, the robustness of the semiconductor module arrangements still needs to be guaranteed and isolation failures between parallel conducting layers, for example, should be avoided.

Document US 2013/0277846 A1 discloses a circuit arrangement providing a substrate, a connecting element and a chip. The substrate provides at least a partial metallization on its surface. The connecting element is applied to the metallization. The chip is applied to the connecting element. The connecting element provides an electrically nonconductive glass layer, which is applied directly to the metallization, and an adhesive layer between the chip and the glass layer.

Document JP 2003 198104 A discloses a metal foil that is mechanically polished by polishing means, thereby completely removing deposits because they are ground away together with the exposed surface of the foil. Grooves that are generated in the mechanically treated surface during the polishing process are removed together with the surface in a chemical polishing process by the melting of the foil in the etchant, and this results in a chemically treated flat surface.

Document US 2014/0138710 A1 discloses a semiconductor device including a circuit substrate which is configured with an insulative substrate formed of a ceramic material and provided on its one surface with an electrode formed of a copper material, and a power semiconductor element bonded with the electrode using a sinterable silver-particle bonding material, wherein the electrode has a Vickers hardness of 70 HV or more in its portion from the bonding face with the power semiconductor element toward the insulative substrate to a depth of 50 µm, and has a Vickers hardness of 50 HV or less in its portion at the side toward the insulative substrate.

There is a need for a power semiconductor module arrangement that meets the requirements for such substrates and for a method for producing such a power semiconductor module arrangement.

### SUMMARY

A method for producing a semiconductor substrate, wherein the semiconductor substrate comprises a dielectric insulation layer that is arranged between a first metallization layer and a second metallization layer. The method includes: reducing the roughness of at least the first metallization layer from a first roughness to a second roughness, wherein, before reducing the roughness, the first metallization layer has a first roughness of more than 50µm, and, wherein the roughness of the first metallization layer is reduced to a second roughness of about 15µm or less; and forming a first passivation layer having a first thickness in a direction perpendicular to the surface of the semiconductor substrate on which the passivation layer is arranged, wherein the first passivation layer is an electrically isolating layer, wherein the first metallization layer is arranged between the first passivation layer and the dielectric insulation layer, wherein the first thickness is between about 50 µm and about 100 µm, and wherein forming the first passivation layer comprises depositing a thick film paste on at least parts of the first metallization layer such that the first metallization layer is arranged between the thick film paste and the dielectric insulation layer, and heating the thick film paste, thereby evaporating some or all of the liquid included in the thick film paste.

A semiconductor substrate (not forming part of the invention) includes a dielectric insulation layer, a first metallization layer on a first side of the dielectric insulation layer, and a second metallization layer on a second side of the dielectric insulation layer, wherein the dielectric insulation layer is disposed between the first and the second metallization layer. A first passivation layer is arranged on the first metallization layer, wherein the first passivation layer is an electrically isolating layer, and wherein the first metallization layer has a reduced roughness of about 25 µm or less, about 15 µm or less, or about 7 µm or less.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a direct bonded copper substrate.
Figure 2, including Figures 2A - 2C, schematically illustrates a method for producing a semiconductor substrate for a power semiconductor module arrangement.
Figure 3 is a cross-sectional view of a semiconductor substrate on which a power semiconductor arrangement is arranged.
Figure 4 is a cross-sectional view of the semiconductor substrate of Figure 3 which is arranged on a heat sink.
Figure 5 in a diagram illustrates a definition of the maximum roughness.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

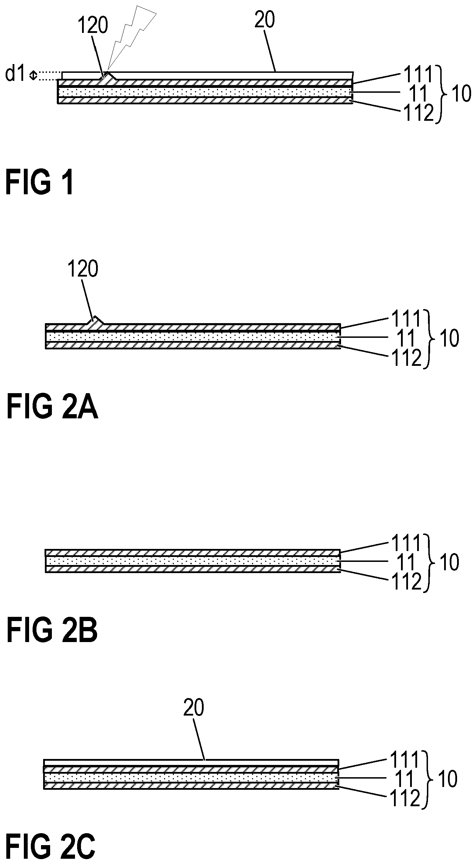

Referring to Figure 1, a semiconductor substrate 10 is illustrated. The semiconductor substrate 10 includes a dielectric insulation layer (11), a (structured) first metallization layer 111 attached to the dielectric insulation layer 11, and a second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminium; an aluminium alloy; any other metal or alloy that remains solid during the operation of the power semiconductor module arrangement. The dielectric insulation layer 11 may be a ceramic, e.g., a thin ceramic layer. The ceramic may consist of or include one of the following materials: aluminium oxide; aluminium nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. Ceramic substrates usually have a high reliability, good mechanical properties and excellent heat conductivity, as compared to most commonly used substrates such as glass-epoxy substrates, for example. For instance, the substrate 10 may, e.g., be a Direct Copper Bonding (DCB) substrate, a Direct Aluminium Bonding (DAB) substrate, or an Active Metal Brazing (AMB) substrate. The substrate 10 may also be a conventional printed circuit board (PCB) or insulated metal substrate (IMS) having a non-ceramic dielectric insulation layer 11. For instance, a non-ceramic dielectric insulation layer 11 may consist of or include a cured resin or a polymer/ceramic matrix.

One exemplary method used for the production of power electronic substrates is the Direct Bonded Copper (DCB) technology. DCB allows to create copper layers with a thickness of hundreds of micrometers in one processing step. Therefore, this process can be very cost effective in mass production. It is suitable for high current conduction and heat transfer from power electronic components. The first metallization layer 111 and the second metallization layer 112 are usually provided as copper foils, which are bonded to the dielectric insulation layer 11 to form the DCB substrate.

The copper foils are placed on the dielectric insulation layer 11 such that there is a good contact between the foil and the ceramic over the entire area. The copper foils may have a copper oxide layer on their surface. The dielectric insulation layer 11 with the copper foils arranged thereon is heated to a temperature above the eutectic temperature of Cu (copper) and Cu₂O (copper oxide) but below the melting temperature of Cu. The bonding process may be performed within a vacuum chamber. During the bonding process, the copper oxide layer of the copper foil and the ceramic are metallurgically bonded. Similar techniques (e.g., bonding, brazing) may be used for the metallization of different kinds of substrates such as DAB substrates or AMB substrates. One thing that all such techniques have in common is that the surface roughness of the metallization layers is determined by the process that is used to attach the metallization layers to the dielectric insulation layer. The surface roughness usually increases during the mounting process such that the roughness is greater after attaching the metallization layers to the dielectric insulation layer than before.

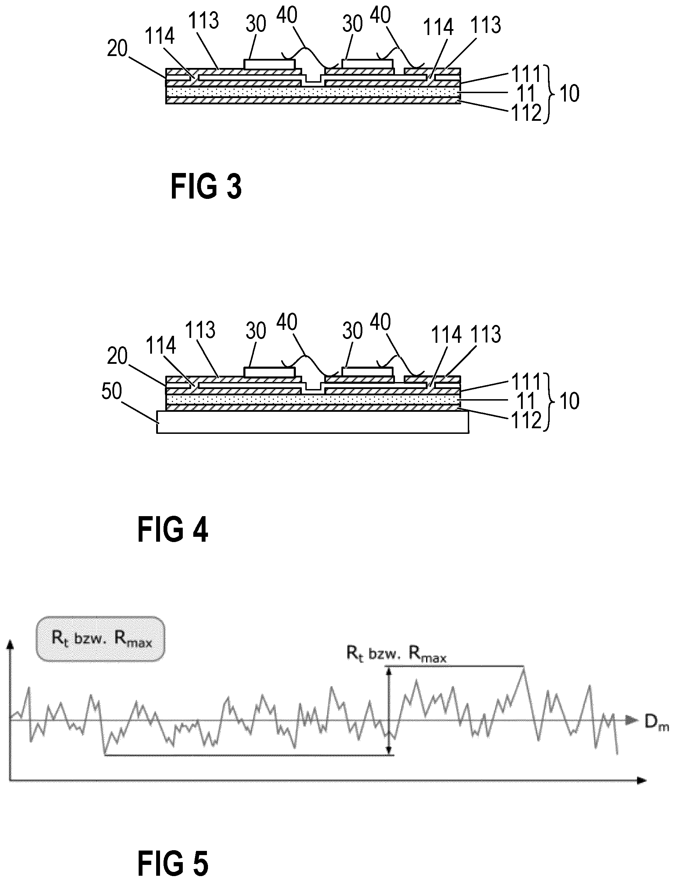

A passivation layer 20 may be arranged on the substrate. For example, the passivation layer 20 may be arranged on the first metallization layer 111, such that the first metallization layer 111 is arranged between the passivation layer 20 and the dielectric insulation layer 11. The passivation layer 20 may be a thick film layer and may have a thickness d1 of up to 50 µm, or up to 100 µm, for example. The thickness d1 of the passivation layer 20 may be a thickness in a direction perpendicular to the surface of the semiconductor substrate 10 on which the passivation layer 20 is arranged. A thickness of between about 50 µm and about 100 µm is a typical thickness for thick film passivation layers. Other thicknesses, however, are also possible. The passivation layer 20 is configured to provide an electrical isolation between the semiconductor substrate 10 and any power semiconductor arrangements that may be arranged on the semiconductor substrate 10. Such a power semiconductor arrangement is not illustrated in Figure 1 and will be described exemplarily further below with regard to Figures 3 and 4.

The first metallization layer 111 and the second metallization layer 112, independent of the kind of substrate, usually have a certain roughness. For common substrates a maximum roughness Rₘₐₓ of the metallization layers 111, 112 usually lies in the dimension of between about 25µm and 50µm or between about 50µm and 100µm. Some substrates are known which are manufactured with a maximum roughness Rₘₐₓ of even less than 25µm, such as 15µm, for example. Roughness means that the metallization layers 111, 112 are not completely flat. The maximum roughness Rₘₐₓ (also referred to as R_{z1max}) is defined in DIN EN ISO 4287 as the arithmetic difference between the deepest and the highest rise of the surface (see Figure 5).

There is usually a plurality of elevations 120 on the surface of the metallization layers 111, 112. One elevation 120 of the first metallization layer 111 is exemplarily illustrated in Figure 1. Each of the plurality of elevations 120 may have a different height, wherein the height is a dimension of the elevations 120 in a direction perpendicular to the surface of the semiconductor substrate 10 on which the metallization layer 111, 112 is arranged. The maximum roughness Rₘₐₓ depends on the maximum height of the elevations. The maximum roughness Rₘₐₓ may be between 15µm and 25µm, between 25µm and 50µm, between 50µm and 100µm, or even greater than 100µm, for example. This means that the maximum roughness may equal the dimensions of the thickness d1 of the passivation layer 20 or may be even greater than the thickness d1 of the passivation layer 20. As the maximum roughness Rₘₐₓ and, therefore, the height of such elevations 120 may equal the thickness d1 of the passivation layer 20, this means that at least some of the elevations 120 may not be completely covered by the passivation layer 20 or that the remaining thickness of the passivation layer 20 above at least some of the elevations 120 may be reduced. The isolating effect of the passivation layer 20, therefore, may be reduced, which may lead to short circuits within a power semiconductor arrangement that is arranged on the semiconductor substrate 10. This is schematically illustrated by means of a flash in Figure 1. Elevations 120 that have a height in the range of the thickness d1 of the passivation layer 20 may also result in unwanted elevations in field strength.

To provide sufficient isolation, it is desirable that the passivation layer 20 has essentially the same thickness d1 over the whole surface of the first metallization layer 111. At least a thickness of the passivation layer above the elevations should be great enough to provide sufficient electrical isolation. This may be achieved by using a method for producing a semiconductor substrate 10 for a power semiconductor module arrangement, which is exemplarily illustrated in Figure 2. As is illustrated in Figure 2A, a semiconductor substrate 10 is provided. The substrate 10 may be a DCB substrate, for example. Other substrates, however, are also possible. The semiconductor substrate 10 has a typical roughness which results from the process that is used to attach the metallization layers 111, 112 to the dielectric insulation layer 11, as has also been described with reference to Figure 1 above. In Figure 2A, one elevation 120 is exemplary illustrated on the first metallization layer 111, representing this typical (maximum) roughness. The first metallization layer 111, however, usually comprises a great number of such elevations. The second metallization layer 112 may have the same or a similar roughness, even if this is not specifically illustrated in Figure 2A.

Before applying a passivation layer 20, the first metallization layer 111 is treated to remove or at least reduce the initial roughness. This means that the first metallization layer 111 has a first (maximum) roughness initially and has a second (maximum) roughness after the treatment, wherein the second roughness is less than the first roughness. For example, the second roughness may be about 25 µm or less, about 15 µm or less, or about 7 µm or less. The second roughness may depend on the voltages that may occur in a power semiconductor arrangement that will be arranged on the semiconductor substrate 10 in a later step. The higher the voltages the passivation layer 20 will have to endure, the smaller the roughness of the first metallization layer 111. A smaller roughness (e.g., 7 µm or less) means that the thickness of the passivation layer 20 is greater, even above any elevations 120 which may remain on the surface of the first passivation layer 111.

The roughness may be reduced such that the dimension of the second roughness is less than 50% of the first thickness d1, less than 40% of the first thickness d1, less than 30% of the first thickness d1, or less than 15% of the first thickness d1. The ratio between the second roughness and the first thickness d1 may depend on the voltages the passivation layer 20 will have to endure. For example, the first passivation layer 20 may have a thickness of 100µm and the (maximum) second roughness may be 25µm (25% of the first thickness d1). According to another example, the first passivation layer 20 may have a thickness of 50µm and the (maximum) second roughness may be 7µm (less than 15% of the first thickness d1). These values, however, are only examples. Any other values may be possible.

Treating the first metallization layer 111 may include polishing, grinding, lapping, chemical-mechanical planarization, or brushing, for example, in order to reduce or remove any elevations and, therefore, reduce the roughness and smoothen the surface of the first metallization layer 111. The suitable processing method and a length of the treatment may be chosen depending on the desired second roughness. For example, to achieve a second roughness of 7 µm, the first metallization layer 111 may be treated for a longer time as compared to a case where a second roughness of only 25 µm is desired. It is, alternatively or additionally, also possible to use a finer grain size of the abrading material to obtain a smaller roughness.

A semiconductor substrate 10 with a reduced roughness is schematically illustrated in Figure 2B. According to one example of the present invention, it is sufficient to treat the first metallization layer 111, while the second metallization layer 112 may remain untreated. The second metallization layer 112, therefore, may still have the first, greater, roughness (e.g., Rₘₐₓ > 25 µm). According to another example, however, the second metallization layer 112 may also be treated to reduce the roughness of the second metallization layer 112 to a third roughness. The third roughness is lower than the first roughness. The third roughness may be the same as the second roughness of the first metallization layer 111. It is, however, also possible that the third roughness is different from the second roughness. This means, that the treated second metallization layer 112 may have a roughness which is different from the roughness of the treated first metallization layer 111. For example, the maximum roughness Rₘₐₓ of the first metallization layer 111 may be reduced to about 7 µm or less, while the maximum roughness Rₘₐₓ of the second metallization layer 112 is reduced to about 15 µm or less. However, as mentioned above, it is also possible that the second metallization layer 112 remains untreated.

After reducing the roughness of at least the first metallization layer 111, a passivation layer 20 may be formed on the first metallization layer 111. The passivation layer 20 may include a non-ceramic material. For example, the passivation layer 20 may include glass. The passivation layer 20, however, may also include a ceramic material. For forming the passivation layer 20, a thick film paste may be applied to a surface of the first metallization layer 111 which faces away from the dielectric insulation layer 11. To apply the thick film paste to the first metallization layer 111, a screen printing technique may be used, for example. The thick film paste may be liquid, viscous or wax-like.

A drying step may follow to form the passivation layer 20. While drying the paste, some or all of the liquid of the paste may be evaporated. The drying step may comprise heating the thick film paste. For example, the paste may be heated to temperatures of up to 600 °C. It is possible that the drying step is performed in a heating chamber. The heating chamber may provide a nitrogen atmosphere, for example. The thick film paste may include glass and a binding agent, for example. During the drying process, the binding agent evaporates and the glass is melted and forms a substance-to-substance bond with the first metallization layer 111. After the drying step, the resulting passivation layer 20, therefore, is hardened and no longer liquid, viscous or wax-like.

The passivation layer 20 being a thick film layer is only one example. It is generally also possible that the passivation layer 20 be provided as an insulating foil that is placed on the first metallization layer 111 and permanently connected to the first metallization layer 111 in a suitable way. Different methods for forming passivation layers 20 are known and will not be described in further detail.

The first metallization layer 111 and the passivation layer 20 may be continuous layers, as is exemplary illustrated in Figure 2C. This, however, is only an example. The first metallization layer 111, the passivation layer 20 or both may also be structured layers. "Structured layer" means that the respective layer is not a continuous layer, but includes recesses between different sections of the layer. Such recesses of the first metallization layer 111 and the passivation layer 20 are schematically illustrated in Figure 3. The first metallization layer 111 in this example includes two different sections. Different sections of the first metallization layer 111 may have no electrical connection or may be electrically connected to one or more other sections using, e.g., bonding wires. Electrical connections may also include connection plates or conductor rails, for example, to name just a few examples.

The passivation layer 20 may completely cover the first metallization layer 111 or may cover only parts of the first metallization layer 111. The passivation layer 20 may also cover parts of the dielectric insulation layer 11, namely such parts that are not covered by the first metallization layer 111. A third metallization layer 113 may be arranged on the passivation layer 20 such that the passivation layer 20 is arranged between the first metallization layer 111 and the third metallization layer 113. The third metallization layer 113 may include the same material as the first metallization layer 111 (e.g., copper, a copper alloy, aluminium, an aluminium alloy, or any other metal or alloy). The first metallization layer 111 and the third metallization layer 113 may be electrically coupled by means of interlayer connections 114. The third metallization layer 113 may be a continuous layer or may be a structured layer. In the example illustrated in Figure 3, the third metallization layer 113 includes three different sections. In the example illustrated in Figure 3, a first section of the third metallization layer 113 is electrically connected to a first section of the first metallization layer 111 via an interlayer-connection 114, and a second section of the third metallization layer 113 is electrically connected to a second section of the first metallization layer 111 via an interlayer-connection 114. A third section of the third metallization layer 113 is not directly electrically connected to the first metallization layer 111.

One or more interlayer-connections 114 may be formed using a thick film technique, as has been described with respect to the passivation layer 20 before. Further passivation layers and metallization layers (e.g., third metallization layer) may also be formed using thick film techniques or by applying respective foils, for example. In order to form metallization layers or interlayer-connections 114, e.g., a paste or foil may be applied to an underlying layer which includes a metal (e.g., a precious metal), for example. For example, the paste or foil may include copper, a copper alloy, aluminium, an aluminium alloy, or any other metal or alloy. If a thick film technique is used, a following drying step is similar to the drying step that has been explained with regard to the first passivation layer 20 before. The thick film paste including the metal may be heated (e.g., up to 600 °C). The heating chamber may provide an inert gas atmosphere such as a pure nitrogen atmosphere, for example.

A structured layer (passivation layer or metallization layer) may be formed in different ways. For example, first a continuous layer may be formed which is subsequently structured. A continuous layer may be structured using an etching process, for example. Any sections which shall remain on the semiconductor substrate 10 may be covered in an appropriate way to prevent the section from being etched. Another possibility to form a structured layer is to cover such surfaces which should remain free of the respective layer and apply the thick film paste (or, e.g., the insulating foil) only to those sections of the surface which should be covered by the respective layer. The passivation layer 20 (in particular, e.g., the thick film paste or the insulating foil), therefore, is only deposited on some sections of the surface, while other sections remain free of the paste.

Again referring to Figure 3, a semiconductor body 30 is arranged on the first section of the third metallization layer 113 and a further semiconductor body 30 is arranged on the third section of the third metallization layer 113. This is, however, only an example. Any number of semiconductor bodies 30 may be arranged on any section of the third metallization layer 113. Further, it is also possible that a second passivation layer be arranged on the third metallization layer and that a fourth metallization layer is formed on the second passivation layer. In this way, any number of passivation layers and metallization layers may be formed on the semiconductor substrate 10.

The one or more semiconductor bodies 30 may form a semiconductor arrangement on the semiconductor substrate 30. The one or more semiconductor bodies 30 arranged on the third metallization layer 113 (or on any other metallization layer) may be electrically and mechanically connected to the respective metallization layer 113 by an electrically conductive connection layer (not specifically illustrated in Figure 3). Such an electrically conductive connection layer may be a solder layer, a layer of an electrically conductive adhesive, or a layer of a sintered metal powder, e.g., a sintered silver powder, for example.

A semiconductor body 30 may be mounted on one section of the respective metallization layer 113 and may be electrically connected to another section of the same metallization layer 113. Such an electrical connection between a semiconductor body 30 and a different section of the metallization layer may include at least one bonding wire 40, for example. Each bonding wire 40 may, at respective bonding locations, be wire-bonded directly to both the respective metallization layer 113 and one of the semiconductor bodies 30 arranged on the semiconductor substrate 10. This is, however, only an example. Instead of to the semiconductor body 30, a bonding wire 40 may be wire-bonded to the section of the respective metallization layer 113 on which the semiconductor body 30 is arranged (not illustrated in Figure 3). If a bonding wire 40 is wire-bonded to the respective metallization layer 113 on which the semiconductor body 30 is arranged, the respective section of the metallization layer 113 provides for an electrical connection between the bonding wire 40 and the semiconductor body 30 arranged on the respective section of the metallization layer 113.

As is illustrated in Figure 3, electrical components such as semiconductor bodies 30 and any further metallization layers, for example, may only be arranged on one side of the semiconductor substrate 10 (e.g., the side of the first metallization layer 111). No electrical components and no further metallization layers may be arranged on the second side of the semiconductor substrate 10 (e.g., the side of the second metallization layer 112). Therefore, it might not be necessary to form a passivation layer on the second metallization layer 112.

As is exemplarily illustrated in Figure 4, the semiconductor substrate 10 may be arranged on a heat sink 50. In the illustrated example, only the first metallization layer 111 and any further metallization layers 113 arranged on the side of the first metallization layer 111 carry electrical currents. The second metallization layer 112 on the opposite side of the dielectric insulation layer 11 does not carry electrical currents. Often, when a power semiconductor arrangement is cooled using a heat sink 50, the heat sink 50 is grounded. No further passivation layer may be required on the second side of the semiconductor substrate 10 which is connected to the heat sink 50. The dielectric insulation layer 11 may provide for electrical isolation between the power semiconductor arrangement on the first side of the semiconductor substrate 10 (the side of the first metallization layer 111) and the second metallization layer 112 (as well as any further components, e.g., a heat sink 50) arranged on the second side of the semiconductor substrate 10 (the side of the second metallization layer 112). Using the dielectric insulation layer 11 to provide electrical isolation between the power semiconductor arrangement on the first side and a heat sink 50 on the second side is usually sufficient, especially if the avalanche voltage of the passivation layer 20 on the first side is 2kV or less.

## Claims

1. A method for producing a semiconductor substrate (10), wherein the semiconductor substrate (10) comprises a dielectric insulation layer (11) that is arranged between a first metallization layer (111) and a second metallization layer (112), the method comprising:
reducing a roughness of at least the first metallization layer (111) from a first roughness to a second roughness, wherein, before reducing the roughness, the first metallization layer (111) has a first roughness of more than 25µm, and wherein the roughness of the first metallization layer (111) is reduced to a second roughness of about 15 µm or less; and
forming a first passivation layer (20) having a first thickness (d1) in a direction perpendicular to the surface of the semiconductor substrate (10) on which the passivation layer (20) is arranged, wherein the first passivation layer (20) is an electrically isolating layer, wherein the first metallization layer (111) is arranged between the first passivation layer (20) and the dielectric insulation layer (11), wherein the first thickness (d1) is between about 50 µm and about 100 µm, and wherein forming the first passivation layer (20) comprises
depositing a thick film paste on at least parts of the first metallization layer (111) such that the first metallization layer (111) is arranged between the thick film paste and the dielectric insulation layer (11); and
heating the thick film paste, thereby evaporating some or all of the liquid included in the thick film paste.

2. The method of claim 1, wherein reducing the roughness of at least the first metallization layer (111) from a first roughness to a second roughness comprises at least one of: polishing, grinding, lapping, chemical-mechanical planarization, and brushing.

3. The method of claim 1 or 2, wherein, before reducing the roughness, the first metallization layer (111) has a first roughness of more than 50µm or more than 100µm.

4. The method of any of claims 1 to 3, wherein at least one of
the roughness of the semiconductor substrate (10) is reduced to a second roughness of about 7 µm or less,
the dimension of the second roughness is less than 50% of the first thickness (d1), less than 40% of the first thickness (d1), less than 30% of the first thickness (d1), or less than 15% of the first thickness (d1).

5. The method of any of the preceding claims, further comprising:
forming a power semiconductor arrangement on the first metallization layer (111), the power semiconductor arrangement comprising at least one semiconductor body (30).

6. The method of claim 5, further comprising:
mounting the semiconductor substrate (10) to a heat sink (50), wherein the second metallization layer (112) is arranged between the heat sink (50) and the semiconductor substrate (10);
the heat sink (50) is configured to be grounded; and
the dielectric insulation layer (11) of the semiconductor substrate (10) is configured to provide for a dielectric isolation between the heat sink (50) and the power semiconductor arrangement on the first metallization layer (111).

7. The method of any of claims 1 to 6, wherein the first passivation layer (20) is formed on at least two separate sections of the first metallization layer (111) as a structured passivation layer (20).

8. The method of claim 5 or 6, wherein the first passivation layer (20) is a continuous layer and forming the power semiconductor arrangement comprises structuring the first passivation layer (20).

9. The method of any of the preceding claims, further comprising:
depositing a thick film paste on at least parts of the passivation layer (20) such that the passivation layer (20) is arranged between the thick film paste and the first metallization layer (111); and
heating the thick film paste, thereby evaporating some or all of the liquid included in the thick film paste and forming a third metallization layer (113), wherein the third metallization layer (20) is an electrically conducting layer and wherein the passivation layer (20) is arranged between the third metallization layer (113) and the first metallization layer (111).

10. The method of claim 9, further comprising:
forming at least one interlayer-connection (114) that is configured to provide an electrical connection between the first metallization layer (111) and the third metallization layer (113).

11. The method of any of claims 1 to 10, wherein the thick film paste used to form the first passivation layer (20) comprises glass or a ceramic material and a binding agent.

12. The method of any of claims 4 to 11, wherein the thick film paste used to form the first passivation layer (20) is heated at temperatures of up to about 600 °C.

13. The method of any of claims 4 to 12, wherein the thick film paste used to form the first passivation layer (20) is heated in a nitrogen atmosphere.

## Patentansprüche

1. Verfahren zum Herstellen eines Halbleitersubstrats (10), wobei das Halbleitersubstrat (10) eine dielektrische Isolationsschicht (11) umfasst, die zwischen einer ersten Metallisierungsschicht (111) und einer zweiten Metallisierungsschicht (112) angeordnet ist, wobei das Verfahren umfasst:
Reduzieren einer Rauheit von mindestens der ersten Metallisierungsschicht (111) von einer ersten Rauheit zu einer zweiten Rauheit, wobei vor dem Reduzieren der Rauheit die erste Metallisierungsschicht (111) eine erste Rauheit von über 25 µm aufweist und wobei die Rauheit der ersten Metallisierungsschicht (111) auf eine zweite Rauheit von etwa 15 µm oder weniger reduziert wird; und
Bilden einer ersten Passivierungsschicht (20) mit einer ersten Dicke (d1) in einer Richtung senkrecht zu der Oberfläche des Halbleitersubstrats (10), auf der die Passivierungsschicht (20) angeordnet ist, wobei die erste Passivierungsschicht (20) eine elektrisch isolierende Schicht ist, wobei die erste Metallisierungsschicht (111) zwischen der ersten Passivierungsschicht (20) und der dielektrischen Isolationsschicht (11) angeordnet ist, wobei die erste Dicke (d1) zwischen etwa 50 µm und etwa 100 µm liegt, und wobei das Bilden der ersten Passivierungsschicht (20) umfasst
Abscheiden einer dicken Filmpaste auf mindestens Teilen der ersten Metallisierungsschicht (111), so dass die erste Metallisierungsschicht (111) zwischen der dicken Filmpaste und der dielektrischen Isolationsschicht (11) angeordnet ist; und
Erwärmen der Dickfilmpaste, dadurch Verdampfen der in der Dickfilmpaste enthaltenen Flüssigkeit ganz oder teilweise.

2. Verfahren nach Anspruch 1, wobei das Reduzieren der Rauheit mindestens der ersten Metallisierungsschicht (111) von einer ersten Rauheit zu einer zweiten Rauheit mindestens eines der Folgenden umfasst: Polieren, Schleifen, Läppen, chemisch-mechanisches Planarisieren und Bürsten.

3. Verfahren nach Anspruch 1 oder 2, wobei vor dem Reduzieren der Rauheit die erste Metallisierungsschicht (111) eine erste Rauheit von über 50 µm oder über 100 µm aufweist.

4. Verfahren nach einem der Ansprüche 1 bis 3, wobei mindestens eine
der Rauheit des Halbleitersubstrats (10) auf eine zweite Rauheit von etwa 7 µm oder weniger reduziert wird,
die Abmessung der zweiten Rauheit unter 50% der ersten Dicke (d1), unter 40% der ersten Dicke (d1), unter 30% der ersten Dicke (d1) oder unter 15% der ersten Dicke (d1) liegt.

5. Verfahren nach einem der vorhergehenden Ansprüche, weiter umfassend:
Bilden einer Leistungshalbleiteranordnung auf der ersten Metallisierungsschicht (111), wobei die Leistungshalbleiteranordnung mindestens einen Halbleiterkörper (30) umfasst.

6. Verfahren nach Anspruch 5, weiter umfassend:
Montieren des Halbleitersubstrats (10) an einen Kühlkörper (50), wobei
die zweite Metallisierungsschicht (112) zwischen dem Kühlkörper (50) und dem Halbleitersubstrat (10) angeordnet ist;
der Kühlkörper (50) konfiguriert ist, geerdet zu werden; und
die dielektrische Isolationsschicht (11) des Halbleitersubstrats (10) konfiguriert ist, um für eine dielektrische Isolation zwischen dem Kühlkörper (50) und der Leistungshalbleiteranordnung auf der ersten Metallisierungsschicht (111) zu sorgen.

7. Verfahren nach einem der Ansprüche 1 bis 6, wobei die erste Passivierungsschicht (20) auf mindestens zwei getrennten Abschnitten der ersten Metallisierungsschicht (111) als eine strukturierte Passivierungsschicht (20) gebildet wird.

8. Verfahren nach Anspruch 5 oder 6, wobei die erste Passivierungsschicht (20) eine kontinuierliche Schicht ist und das Bilden der Leistungshalbleiteranordnung das Strukturieren der ersten Passivierungsschicht (20) umfasst.

9. Verfahren nach einem der vorhergehenden Ansprüche, weiter umfassend:
Abscheiden einer Dickfilmpaste auf mindestens Teilen der Passivierungsschicht (20), so dass die Passivierungsschicht (20) zwischen der Dickfilmpaste und der ersten Metallisierungsschicht (111) angeordnet ist; und
Erwärmen der Dickfilmpaste, dadurch Verdampfen der in der Dickfilmpaste enthaltenen Flüssigkeit ganz oder teilweise und Bilden einer dritten Metallisierungsschicht (113), wobei die dritte Metallisierungsschicht (20) eine elektrisch leitende Schicht ist und wobei die Passivierungsschicht (20) zwischen der dritten Metallisierungsschicht (113) und der ersten Metallisierungsschicht (111) angeordnet ist.

10. Verfahren nach Anspruch 9, weiter umfassend:
Bilden mindestens einer Zwischenschichtverbindung (114), die konfiguriert ist zum Bereitstellen einer elektrischen Verbindung zwischen der ersten Metallisierungsschicht (111) und der dritten Metallisierungsschicht (113).

11. Verfahren nach einem der Ansprüche 1 bis 10, wobei die zum Bilden der ersten Passivierungsschicht (20) verwendete Dickfilmpaste Glas oder ein Keramikmaterial und ein Bindemittel umfasst.

12. Verfahren nach einem der Ansprüche 4 bis 11, wobei die zum Bilden der ersten Passivierungsschicht (20) verwendete Dickfilmpaste auf Temperaturen von bis zu etwa 600°C erwärmt wird.

13. Verfahren nach einem der Ansprüche 4 bis 12, wobei die zum Bilden der ersten Passivierungsschicht (20) verwendete Dickfilmpaste in einer Stickstoffatmosphäre erwärmt wird.

## Revendications

1. Procédé de fabrication d'un substrat (10) semi-conducteur, le substrat (10) semi-conducteur comprenant une couche (11) diélectrique isolante, qui est disposée entre une première couche (111) de métallisation et une deuxième couche (112) de métallisation, procédé dans lequel :
on réduit une rugosité d'au moins la première couche (111) de métallisation d'une première rugosité à une deuxième rugosité, dans lequel, avant de réduire la rugosité, la première couche (11) de métallisation a une première rugosité de plus de 25 µm, et dans lequel la rugosité de la première couche (111) de métallisation est réduite à une deuxième rugosité d'environ 15 µm ou moins ; et
on forme une première couche (20) de passivation d'une première épaisseur (d1) dans une direction perpendiculaire à la surface du substrat (10) semi-conducteur, sur laquelle la couche (20) de passivation est disposée, la première couche (20) de passivation étant une couche isolante du point de vue électrique, la première couche (111) de métallisation étant disposée entre la première couche (20) de passivation et la couche (11) diélectrique isolante, la première épaisseur (d1) étant comprise entre environ 50 µm et environ 100 µm, et dans lequel former la première couche (20) de passivation comprend
déposer une pâte en film épais sur au moins des parties de la première couche (111) de métallisation, de manière à ce que la première couche (111) de métallisation soit disposée entre la pâte en film épais et la couche (11) diélectrique isolante ; et
chauffer la pâte en film épais, en évaporant ainsi tout ou partie du liquide inclus dans la pâte en film épais.

2. Procédé suivant la revendication 1, dans lequel réduire la rugosité d'au moins la première couche (111) de métallisation d'une première rugosité à une deuxième rugosité comprend au moins l'un d'un : polissage, meulage, rodage, planarisation chimico-mécanique et brossage.

3. Procédé suivant la revendication 1 ou 2, dans lequel, avant de réduire la rugosité, la première couche (111) de métallisation a une première rugosité de plus de 50 µm ou de plus de 100 µm.

4. Procédé suivant l'une quelconque des revendications 1 à 3, dans lequel au moins l'un
de la rugosité du substrat (10) semi-conducteur est réduite à une deuxième rugosité d'environ 7 µm ou moins,
de la dimension de la deuxième rugosité est plus petite que 50% de la première épaisseur (d1), plus petite que 40% de la première épaisseur (d1), plus petite que 30% de la première épaisseur (d1) ou plus petite que 15% de la première épaisseur (d1) .

5. Procédé suivant l'une quelconque des revendications précédentes, comprenant, en outre :
former un agencement de semi-conducteur de puissance sur la première couche (111) de métallisation, l'agencement de semi-conducteur de puissance comprenant au moins un corps (30) semi-conducteur.

6. Procédé suivant la revendication 5, comprenant, en outre :
monter le substrat (10) semi-conducteur sur un puits (50) de chaleur,
la deuxième couche (112) de métallisation étant disposée entre le puits (50) de chaleur et le substrat (10) semi-conducteur ;
le puits (50) de chaleur étant configuré pour être mis à la terre ; et
la couche (11) diélectrique isolante du substrat (10) semi-conducteur est configurée pour fournir une isolation diélectrique entre le puits (50) de chaleur et l'agencement de semi-conducteur de puissance sur la première couche (111) de métallisation.

7. Procédé suivant l'une quelconque des revendications 1 à 6, dans lequel la première couche (20) de passivation est formée sur au moins deux parties distinctes de la première couche (111) de métallisation sous la forme d'une couche (20) de passivation structurée.

8. Procédé suivant la revendication 1 ou 6, dans lequel la première couche (20) de passivation est une couche continue et former l'agencement de semi-conducteur de puissance comprend structurer la première couche (20) de passivation.

9. Procédé suivant l'une quelconque des revendications 1 à 3, comprenant, en outre :
déposer une pâte en film épais sur au moins des parties de la couche (20) de passivation, de manière à ce que la couche (20) de passivation soit disposée entre la pâte en film épais et la première couche (111) de métallisation ; et
chauffer la pâte en film épais en évaporant ainsi, tout ou partie, du liquide inclus dans la pâte en film épais et former une troisième couche (113) de métallisation, la troisième couche (113) de métallisation étant une couche conductrice de l'électricité et la couche (20) de passivation étant disposée entre la troisième couche (113) de métallisation et la première couche (111) de métallisation.

10. Procédé suivant la revendication 9, comprenant, en outre :
former au moins une connexion (114) entre couches, configurée pour donner une connexion électrique entre la première couche (111) de métallisation et la troisième couche (113) de métallisation.

11. Procédé suivant l'une quelconque des revendications 1 à 10, dans lequel la pâte en film épais utilisée pour former la première couche (20) de passivation comprend du verre ou un matériau céramique et un agent liant.

12. Procédé suivant l'une quelconque des revendications 4 à 11, dans lequel la pâte en film épais utilisée pour former la première couche (20) de passivation est portée à des températures allant jusqu'à environ 600°C.

13. Procédé suivant l'une quelconque des revendications 4 à 12, dans lequel la pâte en film épais utilisée pour former la première couche (20) de passivation est chauffée dans une atmosphère d'azote.
